# EUROPEAN PATENT APPLICATION

(11) **EP 2 159 856 A1**
(43) Date of publication of application: **03.03.2010**
(21) Application number: 08765312.7
(22) Date of filing: 03.06.2008
(51) Int. Cl.: H01L 35/32, H02N 11/00

(54) **THERMOELECTRIC CONVERSION MODULE AND THERMOELECTRIC HEAT GENERATION SYSTEM**

(30) Priority: 07.06.2007 JP 2007151844
(71) Applicant: Sumitomo Chemical Company, Limited, Tokyo 104-8260 (JP)
(72) Inventor: HIROYAMA, Yuichi, Tsukuba-shi Ibaraki 300-2617 (JP)
(74) Representative: Hart-Davis, Jason
(86) International application number: PCT/JP2008/060511
(87) International publication number: WO 2008/150007

(57) **Abstract**

The present invention provides a thermoelectric conversion module and a thermoelectric power generation system. The thermoelectric conversion module comprises a thermoelectric device and an electrode fixed to the thermoelectric device, wherein a cavity is formed in the electrode. The thermoelectric power generation system comprises a heat source and the thermoelectric conversion module, wherein heat from the heat source is supplied to the thermoelectric device through the electrode and substrate.

## Description

### TECHNICAL FIELD

The present invention relates to a thermoelectric conversion module and a thermoelectric power generation system.

### BACKGROUND ART

As conventional thermoelectric conversion modules, known are those having a substrate, an electrode fixed to the substrate, and a thermoelectric device fixed to the electrode. As methods for electrically connecting a thermoelectric device and an electrode, known are means of fixing with a joining material such as solder (e.g., JP-A-5-41543) and means of mutual fixing by inserting a part of a thermoelectric device into a hole of an electrode without using a joining material (e.g., JP-A-2006-253343).

### DISCLOSURE OF THE INTENTION

However, usually, the thermal expansion coefficient of an electrode is significantly larger than the thermal expansion coefficient of a thermoelectric device and a substrate in many cases, and due to this difference in thermal expansion coefficient, heat stress tends to occur between the electrode and the thermoelectric device or between the electrode and the substrate when temperature rises in use. Thus, for example, when a difference in temperature between the lower temperature side and the higher temperature side is increased to attain efficient power generation, there is a possibility that, because of heat stress, troubles such as crack occur at the joining part of the electrode and the thermoelectric device, and the electrode is peeled from the substrate, thereby deteriorating the reliability of the thermoelectric conversion module.

The present invention has been made under these circumstances and has an object of providing a thermoelectric conversion module with higher reliability and a thermoelectric power generation system comprising the thermoelectric conversion module.

The first thermoelectric conversion module according to the present invention comprises a thermoelectric device and an electrode fixed to the thermoelectric device, wherein a cavity is formed in the electrode.

The second thermoelectric conversion module according to the present invention comprises a thermoelectric device, an electrode connected electrically to the thermoelectric device and a substrate to which the electrode is fixed, wherein a cavity is formed in the electrode.

In these modules of the present invention, a cavity is formed in the electrode. That is, since the cavity itself is capable of easily expanding and shrinking, and changing in shape, thus, even if there is a variation in temperature, heat stress between the electrode and the thermoelectric device or heat stress between the electrode and the substrate is relaxed.

The cavity can be a porous hole, an open space between mesh wires or a through hole.

The thermoelectric power generation system according to the present invention comprises a heat source and the above-described first thermoelectric conversion module, wherein heat from the heat source is supplied to the thermoelectric device through the electrode.

The second thermoelectric power generation system according to the present invention comprises a heat source and the above-described second thermoelectric conversion module, wherein heat from the heat source is supplied to the thermoelectric device through the electrode and substrate.

The electrode for the thermoelectric conversion module of the present invention is preferably formed from metal composed of, as a main component, at least one selected from the group consisting of titanium, vanadium, chromium, manganese, iron, cobalt, nickel, copper, molybdenum, silver, palladium, gold, tungsten and aluminum. The heat resistance, corrosion resistance and adhesion to a thermoelectric device of the electrode can be improved.

### RRTFF EXPLANATION OF DRAWINGS

Fig. 1 is a cutaway side view showing a thermoelectric conversion module as one embodiment of the present invention.
Fig. 2 is a partial cross-sectional view showing a second electrode of the thermoelectric conversion module shown in Fig. 1.
Fig. 3 is a perspective view showing a variation of an electrode of a thermoelectric conversion module according to the present invention.
Fig. 4 is a perspective view showing a variation of an electrode of a thermoelectric conversion module according to the present invention.
Fig. 5 is a schematic view showing a thermoelectric power generation system according to the present invention.

### Explanation of Symbols

1 thermoelectric conversion module
2 first substrate
3 first electrode
4 thermoelectric device
6 second electrode
7 second substrate
8 cavity
9 joining material

### MODES FOR CURRYING OUT THE INVENTION

The finding of the present invention can be understood easily by considering the following detailed descriptions referring to appended figures shown only for examples. Embodiments of the present invention will be described referring to appended figures. If possible, the same symbol is used for the same element, and duplicated explanations are omitted.

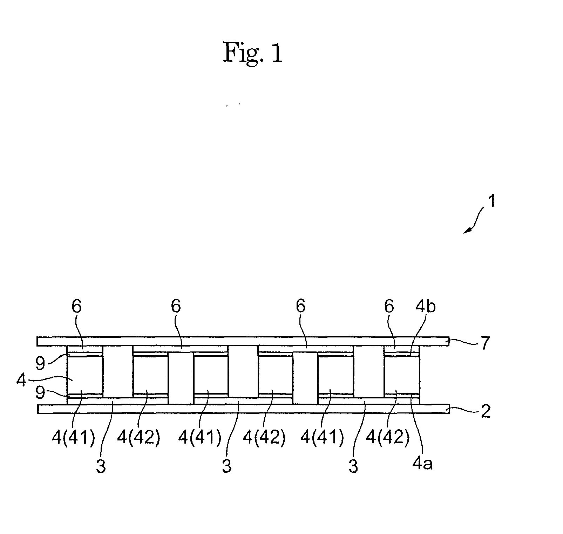

Fig. 1 is a cutaway side view showing a thermoelectric conversion module 1 as one embodiment of the present invention. As shown in Fig. 1, thermoelectric conversion module 1 has a first substrate 2, a first electrode 3, a thermoelectric device 4, a second electrode 6 and a second substrate 7. In the thermoelectric conversion module 1, the side of the first substrate 2 is a relatively lower temperature side and the side of the second substrate 7 is a relatively higher temperature side.

The first substrate 2 has, for example, a rectangular shape, and has an electric insulation property and thermal conductivity, and covers one end of the thermoelectric device 4. Examples of the material of this first substrate include alumina, aluminum nitride, and magnesia.

The first electrode 3 is provided on the first substrate 2, and electrically connects mutually one-end surfaces 4a of mutually adjacent thermoelectric devices 4. The first electrode 3 can be formed on a prescribed position on the first substrate 2 using, for example, a thin film technology such as sputtering, and vapor deposition, or screen printing, plating, and thermal spraying. A metal plate having a prescribed shape and the like may also be connected onto the first substrate 2 by soldering, brazing and the like. The material of the first electrode 3 is not particularly limited provided that it has electric conductivity, and preferable are metals containing as a main component at least one selected from the group consisting of titanium, vanadium, chromium, manganese, iron, cobalt, nickel, copper, molybdenum, silver, palladium, gold, tungsten and aluminum to improve the heat resistance, corrosion resistance and adhesion to a thermoelectric device of the electrode. The main component means a component contained in a proportion of not less than 50% by volume in the electrode material.

The thermoelectric device 4 is, for example, a rod-shaped member having a rectangular cross-section, and includes a p-type thermoelectric device 41 and an n-type thermoelectric device 42.

Examples of the material of this p-type thermoelectric device include metal mixed oxides such as Ca₃CO₄O₉, and NaₓCoO₂, silicides such as MnSi_{1.73}, Fe₁₋ₓMnₓSi₂, Si_{0.8}Ge_{0.2}, and β-FeSi₂, skutterudites such as CoSb₃, FeSb₃, and RFe₃CoSb₁₂ (R represents La,Ce or Yb), Te-containing alloys such as BiTeSb, and PbTeSb. Examples of the material of the n-type thermoelectric device include metal mixed oxides such as SrTiO₃, Zn₁₋ₓAlₓO, CaMnO₃, LaNiO₃, BaₓTi₈O₁₆, and Ti₁₋ₓNbₓO, silicides such as Mg₂Si, Fe₁₋ₓCoₓSi₂, Si_{0.8}Ge_{0.2}, and β-FeSi₂, skutterudites, clathrate compounds such as Ba₈Al₁₂Si₃₀, and Ba₈Al₁₂Ge₃₀, boron compounds such as CaB₆, SrB₆, BaB₆, and CeB₆, Te-containing alloys such as BiTeSb, and PbTeSb. Of them, thermoelectric devices made of a metal mixed oxide are preferable from the standpoint of production cost and stability in air, and a combination of Ca₃CO₄O₉ as the p-type thermoelectric device and CaMnO₃ as the n-type thermoelectric device is particularly preferable. These thermoelectric devices can be suitably used in a power generator which uses a heat source of high temperature since these devices manifest a high thermoelectric property particularly at about 700 to 800°C. More specifically, the particularly suitable used temperature range is, for example, 300 to 570 K for BiTe, 300 to 850 K for PbTe, 500 to 800 K for the silicide such as MnSi, and MgSi, 500 to 750 K for ZnSb, 300 to 900 K for CoSb (skutterudite), and about 500-1100 K for the oxide.

The second substrate 7 has, for example, a rectangular shape and covers another end of the thermoelectric device 4. The second substrate 7 is not particularly limited provided that it has an electric insulation property and thermal conductivity like the first substrate 2, and for example, materials such as alumina, aluminum nitride, and magnesia can be used.

The second electrode 6 electrically connects mutually another-end surfaces 4b of mutually adjacent thermoelectric devices 4, and can be formed on the second substrate 7 using, for example, a thin film technology such as sputtering, and vapor deposition, or screen printing, plating, and thermal spraying. The thermoelectric devices 4 are connected electrically serially using the second electrode 6 and the first electrode 3 provided on the side of one end surface 4a of the thermoelectric device 4.

The p-type thermoelectric devices 41 and the n-type thermoelectric devices 42 are disposed side by side alternately between the first substrate 2 and the second substrate 7, and fixed to the surfaces of the first electrode 3 and the second electrode 6 corresponding to the surfaces of these devices by a joining material 9 such as AuSb or PbSb solder and silver paste and are totally electrically serially connected. As the joining material, those which are solid in use as a thermoelectric device are preferable.

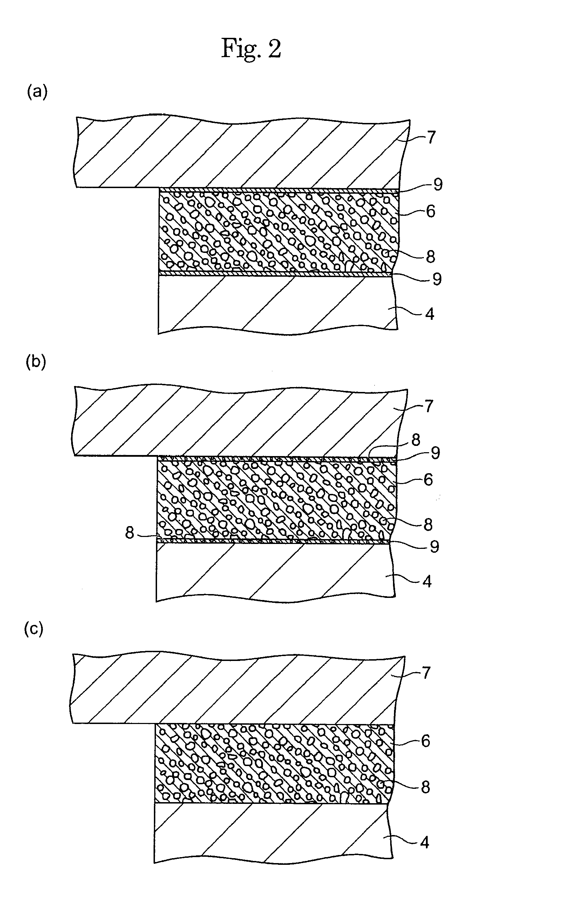

Fig. 2 is a partial cross-sectional view of the second electrode 6. As shown in Fig. 2(a), the second electrode 6 is provided with many cavities 8. The cavity 8 may be a closed cavity not opened to the surface of the second electrode 6, or may be a cavity opened to the surface of the second electrode 6. The cavity is a hole of which internal part is not filled completely with the joining material 9 or a part of the thermoelectric device 4, and which at least partially has a portion accommodating a gas. The gas is not particularly limited. Examples of the gas include an atmosphere gas of a place in which the thermoelectric device is used, and an atmosphere gas in fabricating the second electrode 6. It is preferable that a part of the electrode or the whole electrode is porous so as to form many cavities easily, as shown in Fig. 2. In the present invention, the cavity diameter and cavity ratio, which is a proportion (% by volume) of the total volume of the cavities with respect to the apparent volume of the electrode, vary depending on the materials constituting the electrode, substrate and thermoelectric device, and may be appropriately set depending on the difference in thermal expansion coefficient between the electrode and the substrate or the thermoelectric device, and the cavity ratio is preferably 30% by volume to 90% by volume. In the present invention, the joining material 9 may have a cavity 8 like the electrode 6 (see, Fig. 2(b)).

The porous electrode 6 can be fabricated by, for example, a so-called slurry foaming method as described below. In the method, a water-insoluble hydrocarbon organic solvent having about 5 to 8 carbon atoms, a surfactant, a water-soluble resin binder, a metal powder and water are mixed in prescribed amounts to prepare a metal paste. The metal paste is formed by a conventional method such as a doctor blade to obtain a formed body with a prescribed shape. The formed body is kept at a high temperature, for example, of not lower than 5°C. Thus, the water-insoluble hydrocarbon organic solvent vaporizes and is removed from the formed body to obtain a porous formed body containing fine bubbles generated in the formed body. Further, the porous formed body is sintered to obtain a porous electrode. Fabrication method of the porous electrode 6 is not limited to this, and it may also be fabricated by, for example, sintering of metal spheres or metal fiber, or plating of a metal on the surface of a foamed resin before removal by decomposition of the resin. When the cavity 8 of the second electrode 6 is porous, many cavities 8 can be formed easily.

The position of the cavity 8 in the second electrode 6 is not particularly limited, it is preferably placed at a portion of fixation to each thermoelectric device 4 to relax heat stress against the thermoelectric device 4, and it is preferably placed at a portion of fixation to the second substrate 7 to relax heat stress against the second substrate 7.

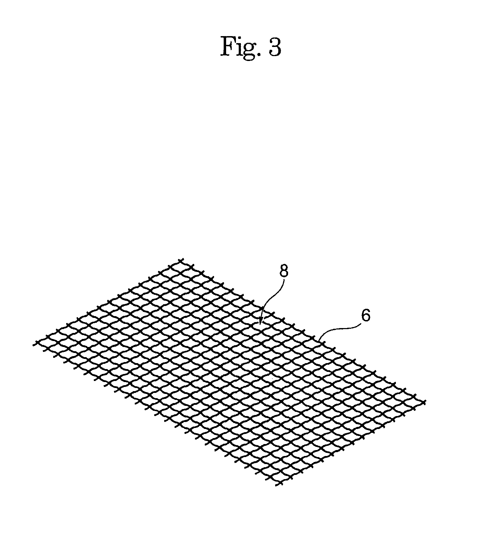

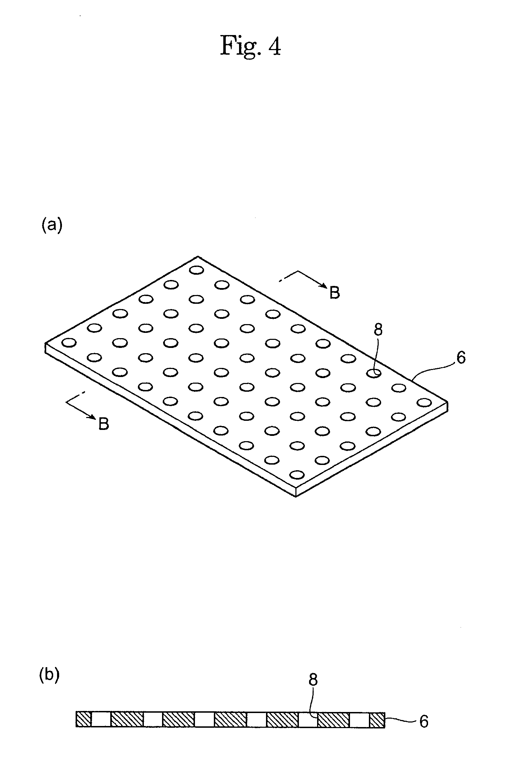

The cavity 8 is not necessarily porous. Fig. 3 and Fig. 4 are views showing variations of the second electrode 6. As shown in Fig. 3, it may be a cavity 8 which is an open space between mesh wires fabricated as an electrode or as shown in Fig. 4(a) and Fig. 4(b) as a B-B sectional view of (a), it may be a cavity 8 formed by preparing a through hole in the electrode. In all embodiments, the cavity 8 can be formed easily.

The material of the second electrode 6 is not particularly limited provided that it has electric conductivity and it is not melted in the used temperature range, preferable are metals containing as a main component at least one selected from the group consisting of titanium, vanadium, chromium, manganese, iron, cobalt, nickel, copper, molybdenum, silver, palladium, gold, tungsten and aluminum to improve the heat resistance, corrosion resistance and adhesion to a thermoelectric device of the electrode.

In the thermoelectric conversion module 1, the cavity 8 is formed in the second electrode 6. Thus, even if the second electrode 6 and the thermoelectric device 4 expand thermally and heat stress occurs between the second electrode 6 and the thermoelectric device 4 due to a difference in thermal expansion coefficient between the second electrode 6 and the thermoelectric device 4 in use thereof, the heat stress can be relaxed by expansion, shrinkage, and change in shape of the cavity 8. That is, crack occurrence at a connecting portion of the second electrode 6 and the thermoelectric device 4 can be reduced. Therefore, the temperature at the higher temperature side of the thermoelectric conversion module 1 can be further increased. Also when heat stress occurs between the second electrode 6 and the second substrate 7 due to a difference in thermal expansion coefficient between the second electrode 6 and the second substrate 7, heat stress can be relaxed likewise. Thus, peeling of the second electrode 6 from the second substrate 7 can also be reduced. The temperature at the higher temperature side can be further increased easily, and efficient thermoelectric conversion can be performed.

Suitable embodiments of the present invention are described above, but the present invention is not limited to the embodiments.

For example, for the thermoelectric device 4, a metal film may also be formed on the surface of the connecting side to the electrode. The wettability of the joining material 9 to the thermoelectric device 4 is improved, thus, the thermoelectric device 4 and the electrodes 3 and 6 are electrically connected tightly.

The first electrode 3 may also have a structure with a cavity 8 like the second electrode 6.

Further, it is also possible to adopt a configuration not having the first substrate 2 and the second substrate 7. For example, a so-called skeleton type thermoelectric conversion module having no substrates 2 and 7 can also be obtained by supporting the thermoelectric devices 4 using a holder formed from a material having a thermal insulation property and electric insulation property and having a plurality of rectangular through holes formed corresponding to the cross-sectional form of the thermoelectric device 4.

On the other hand, as shown in Fig. 2(c), the second electrode 6 and the thermoelectric device 4 is not necessarily fixed by a joining material 9 and allowed to contact in sliding mode, or the second electrode 6 and the thermoelectric device 4 may also be electrically connected by allowing metal which is in liquid state in use to intervene. In this case, heat stress between the second electrode 6 and the thermoelectric device 4 is not problematical, and according to the present invention, it contributes to relaxation of heat stress between the second electrode 6 and the second substrate 7.

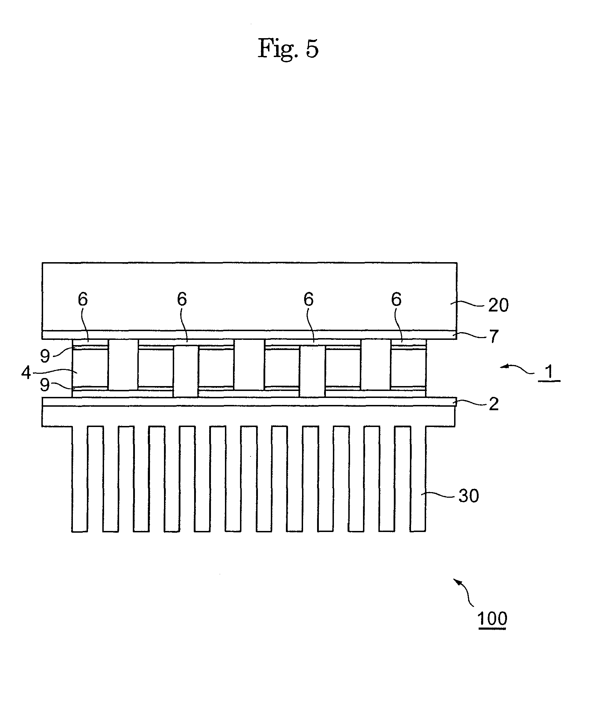

Next, the thermoelectric power generation system according to the present invention will be illustrated referring to Fig. 5. The thermoelectric power generation system according to this embodiment has a heat source 20, a thermoelectric conversion module 1, and a cooling fin 30. The heat source 20 is not particularly limited, and examples thereof include apparatus emitting waste heat, such as converters, compressors, engines, pumps, and plumbing in which a high temperature fluid flows through.

The thermoelectric conversion module 1 is placed so that a second substrate 7 is thermally connected to the heat source 20. The cooling fin 30 is thermally connected to a first electrode 2. The cooling fin 2 is not essential. The material of the cooling fin 30 is not particularly limited, and examples thereof include metals such as aluminum.

Using the thermoelectric conversion system, it is possible to generate electric power from waste heat of the heat source 20 by using a thermoelectric conversion module.

### INDUSTRIAL APPLICABILITY

Using the present invention, there are provided a thermoelectric conversion module with higher reliability in which heat stress of an electrode is relaxed, and a thermoelectric power generation system comprising the module.

## Claims

1. A thermoelectric conversion module comprising a thermoelectric device and an electrode fixed to the thermoelectric device, wherein a cavity is formed in the electrode.

2. A thermoelectric conversion module comprising a thermoelectric device, an electrode electrically connected to the thermoelectric device, and a substrate to which the electrode is fixed, wherein a cavity is formed in the electrode.

3. An electrode for the thermoelectric conversion module according to claim 1 or 2, comprising a cavity wherein the cavity is a porous hole.

4. An electrode for the thermoelectric conversion module according to claim 1 or 2, comprising a cavity wherein the cavity is an open space between mesh wires.

5. An electrode for the thermoelectric conversion module according to claim 1 or 2, comprising a cavity wherein the cavity is a through hole.

6. A thermoelectric power generation system comprising a heat source and the thermoelectric conversion module according to claim 1, wherein heat from the heat source is supplied to the thermoelectric device through the electrode.

7. A thermoelectric power generation system comprising a heat source and the thermoelectric conversion module according to claim 2, wherein heat from the heat source is supplied to the thermoelectric device through the electrode and the substrate.
